**Europäisches Patentamt**

**European Patent Office**

**Office européen des brevets**

(19)

(11) Veröffentlichungsnummer: **0 043 536**
A2

# (12) EUROPÄISCHE PATENTANMELDUNG

(21) Anmeldenummer: **81105053.3**

(22) Anmeldetag: **30.06.81**

(51) Int. Cl.³: **G 05 B 13/02,** H 03 J 7/08, H 03 K 13/05

(30) Priorität: **04.07.80 DE 3025358**

(43) Veröffentlichungstag der Anmeldung: **13.01.82** Patentblatt 82/2

(84) Benannte Vertragsstaaten: **DE FR GB IT NL**

(71) Anmelder: **Deutsche ITT Industries GmbH, Hans-Bunte-Strasse 19 Postfach 840, D-7800 Freiburg (DE)**

(84) Benannte Vertragsstaaten: **DE**

(71) Anmelder: **ITT INDUSTRIES, INC., 320 Park Avenue, New York, NY 10022 (US)**

(84) Benannte Vertragsstaaten: **FR GB IT NL**

(72) Erfinder: **Klee, Heinz, Dipl.-Ing., Nelkenweg 2, D-7800 Freiburg i. Br. (DE)**

(74) Vertreter: **Stutzer, Gerhard, Dr., Deutsche ITT Industries GmbH Patent- und Lizenzabteilung Hans-Bunte-Strasse 19 Postfach 840, D-7800 Freiburg (DE)**

(54) Regelsystem zum Einstellen einer physikalischen Grösse.

(57) Es wird ein sich selbst mittels eines Rechners (2) abgleichendes Regelsystem zum Einstellen einer physikalischen Größe auf einen digital vorgegebenen Sollwert mittels eines Abgleichelements (4), beispielsweise der Resonanzfrequenz eines Oszillatorkreises mittels einer Kapazitätsdiode, beschrieben. Dabei wird im Rechner (2) der digital vorgegebene Sollwert A in ein Wort B überführt und die Summe von B mit einem Korrekturwort $\Delta B$ gebildet, welches vom Rechner (2) durch Differenzbildung von A mit einem Wort C entsprechend dem Istwert der physikalischen Größe ermittelt wird. Die Summe $B + \Delta B$ wird entsprechend der Erfindung an den Eingang eines D/A-Wandlers (3) angelegt, der einen ersten Wandlerteil (31) mit einem fein abgestuften Bereich (S1 ... Sm) und einen zweiten Wandlerteil (32) mit einem grob abgestuften Bereich (Sm+1 ... Sm) aufweist, wobei die Summe der Ströme I1 bis Im größer ist als der Strom Im+1 und der Strom Im+2 gleich Im+1 oder gleich 2.Im+1 ist.

H.Klee-1

Fl 1044 EP
Go/bk
24. Juni 1981

## Regelsystem zum Einstellen einer physikalischen Größe

Die Erfindung beschäftigt sich mit einem Regelsystem zum Einstellen einer physikalischen Größe irgendeiner Vorrichtung auf einen mittels eines Sollwertgebers vorgegebenen Sollwert, beispielsweise die Temperatur einer elektrischen Heizvorrichtung, die Drehzahl eines Elektromotors oder auch die Resonanzfrequenz eines Schwingungskreises unter Verwendung eines elektronisch beeinflußbaren Abgleichelements, an welches ein analoges Abgleichsignal angelegt wird.

Dabei ist zu denken an einen elektronisch beeinflußbaren Widerstand, mit dem der elektrische Strom durch den Ofen oder auch der des Elektromotors beeinflußt und geregelt wird. Im Falle eines Schwingungskreises wäre als Abgleichelement zur Einstellung der Resonanzfrequenz eine Kapazitätsdiode brauchbar, deren Kapazität bekanntlich spannungsabhängig ist.

Die Erfindung betrifft somit ein Regelsystem gemäß dem Oberbegriff des Anspruchs 1.

Die Erfindung geht von dem Gedanken aus, den Sollwert der physikalischen Größe mittels eines Tastenfeldes digital einzugeben, einen D/A-Wandler zwischen das Abgleichelement und den Sollwertgeber zu schalten, aus dem Istwert der physikalischen Größe einen digitalen Wert (Wort) zu bilden, der mit dem Sollwert verglichen wird und schließlich mittels eines elektronischen Rechners (Mikroprozessors) einen Korrekturwert dem in den D/A-Wandler eingegebenen
Signal aufzuprägen, so daß der Sollwert der physikalischen
Größe der betreffenden Vorrichtung mittels des Abgleichelementes eingestellt wird.

Aufgabe der Erfindung ist die Angabe eines schnell arbeitenden Regelsystems, welches, abgesehen von dem Sollwertgeber
und dem Abgleichelement aus integrierten Schaltungen aufgebaut werden kann.

Diese Aufgabe wird erfindungsgemäß durch den im Anspruch
angegebenen Aufbau gelöst.

Doch auch bei einem solchen Regelsystem kann im allgemeinen
beim Tastenfeld von Schaltern und dem Abgleichelement auf
mechanisch bewegte Bauteile verzichtet werden, wie es
bei handelsüblichen Fernsehgeräten üblich ist. Gerade an
eine solche Verwendung eines Regelsystems nach der Erfindung bei einem Fernsehempfänger oder bei einem hochwertigen Tuner für Rundfunkempfang wird gedacht.

Die Erfindung wird im folgenden anhand einer solchen Anwendung erläutert.

Bei hochwertigen Tunern werden gegenwärtig phasengeregelte
Regelsysteme (PLL) verwendet, bei denen die Glättung der
an einer Kapazitätsdiode angelegten Abgleichspannung mittels
Kondensatoren mit relativ großen Kapazitäten unerläßlich
ist. Solche Kondensatoren können nicht ohne erheblichen
Aufwand an Kristallfläche in integrierte Schaltungen einbezogen werden. Ein weiterer Nachteil solcher Kondensatoren
besteht darin, daß der Abgleichvorgang mehrere m·Sekunden
erfordert.

0043536

H.Klee-1                                    Fl 1044 EP

Diese Nachteile werden bei einer Anwendung des Regelsystems nach der Erfindung zur Abstimmung von Tunern
vermieden, worauf sich das Ausführungsbeispiel bezieht,
welches anhand der Zeichnung erläutert wird,

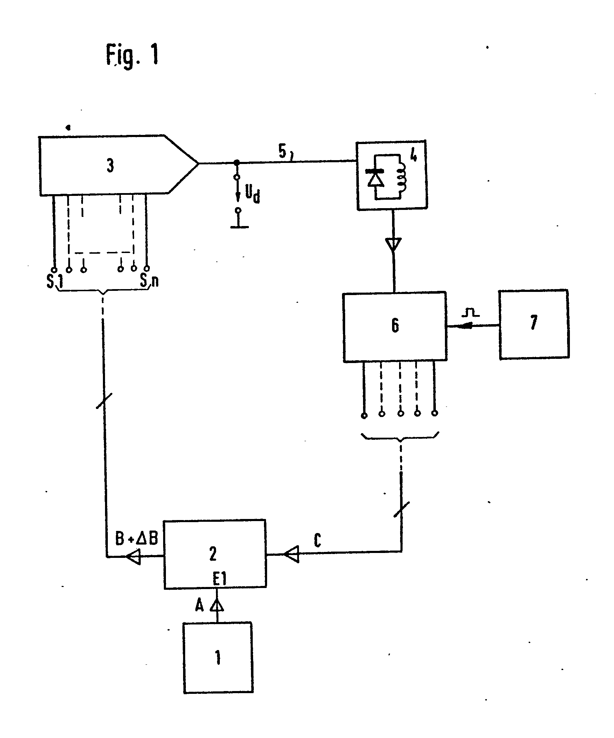

deren Fig. 1    das Regelsystem nach der Erfindung
                enthält,

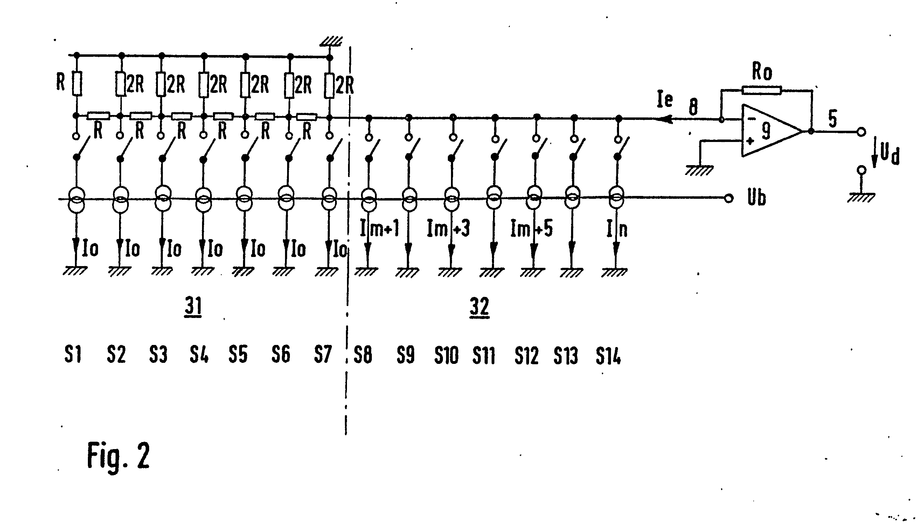

deren Fig. 2    das Prinzipschaltbild des für das
                Regelsystem nach der Erfindung vorge-
                sehenen D/A-Wandlers zeigt und

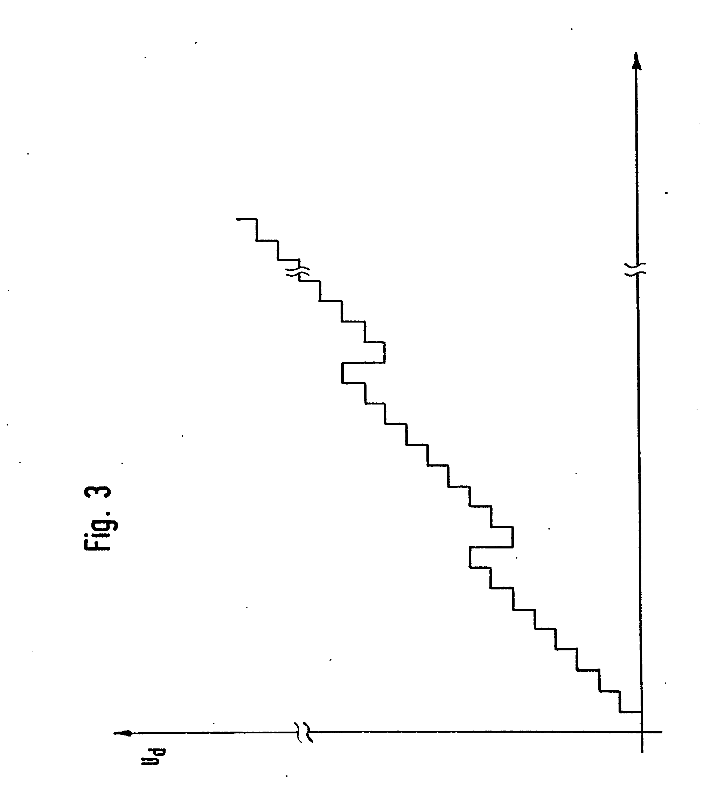

deren Fig. 3    schematisch eine Wandlerkennlinie zur
                Erläuterung der Funktionsweise des Regel-
                systems nach der Erfindung veranschau-
                licht.

Das Regelsystem nach der Erfindung läßt sich bis auf den
D/A-Wandler mit handelsüblichen integrierten Schaltungen
realisieren. Dieser Wandler, der somit als wesentlicher
Bestandteil der Erfindung anzusehen ist, soll daher zunächst ausführlich beschrieben werden.

Durch Fertigungstoleranzen bei monolithisch integrierten
D/A-Wandler sind die Linearität, Monotonie und das Auflösungsvermögen begrenzt. In dem für das Regelsystem nach
der Erfindung erforderlichen Wandler sind mindestens zwei
Wandlerteile vorgesehen, von denen ein erster Wandlerteil
einen fein abgestuften Bereich und ein zweiter Wandlerteil einen grob abgestuften Bereich aufweisen. Bei dem
Wandler des Ausführungsbeispiels zur rechner-gesteuerten
Tunerabstimmung sind zwei Wandlerteile für zwei verschiedene Arbeitsbereiche vorgesehen.

H.Klee-1 Fl 1044 EP

An den fein abgestuften Bereich sind die bei integrierten D/A-Wandlern bekannten Anforderungen hinsichtlich der Monotonie zu stellen, welche durch geringe Fertigungstoleranzen und Verwendung von topologisch gleichen Strukturen in etwa erfüllt werden können. So sollten möglichst topologisch gleiche Transistoren, beispielsweise Feldeffekttransistoren, zur Realisierung der Widerstände bzw. der Stromquellen bei der Auslegung verwendet werden.

Die Fig. 2 zeigt das Prinzipschaltbild eines 10-Bit-Wandlers, der einen ersten Wandlerteil 31 mit einem fein abgestuften Bit-Bereich S1 bis S7 und einen zweiten Wandlerteil 32 mit einem grob abgestuften Bit-Bereich S8 bis S14 enthält. In jeder Bitleitung liegen in Reihe zwischen dem Bezugspotential und der Summierleitung 8, die im Wandlerteil 31 in Reihe geschaltete gleich große Widerstände R enthält, je eine Stromquelle und ein elektronischer Schalter, dessen Steuerleitung an den Rechner 2 gemäß der Fig. 1 angeschlossen wird. Die Steuerelektroden der Stromquellen liegen gemeinsam an der Vorspannung Ub; im Falle der Verwendung von Feldeffekttransistoren als Spannungsquellen werden die Gate-Elektroden somit an die Spannung Ub gelegt.

Die Verbindungspunkte der Serienwiderstände mit dem Widerstand R sind über Querwiderstände mit Widerstandswerten 2R an das Bezugspotential gelegt. Das somit erhaltene 2R-R-Netzwerk wird ausgangsseitig mit einem Abschlußwiderstand mit einem Widerstand von 2R und eingangsseitig mit dem Abschlußwiderstand mit dem Widerstandswert von R abgeschlossen, wie die Fig. 2 veranschaulicht. Am Ausgang des Wandlers liegt ein Operationsverstärker 9, dessen Eingang über den Widerstand Ro an dessen Ausgang zur Einstellung der Steilheit gelegt ist. Die Ausgangsspannung $U_d$ des Wandlers wird an die Kapazitätsdiode angelegt.

Der erste Wandlerteil 31 des D/A-Wandlers gemäß der Fig. 2 wird so ausgelegt, daß die Summe der in die Summierleitung 8 eingespeisten Ströme I1 bis I7, die bei Betätigung der entsprechenden Bit-Schalter S1 bis S7 auftreten, größer ist als jeder der einzelnen Ströme Im+1 bis In des zweiten Wandlerteils 32. Dadurch wird jeder Strombereich Im+1 bis In vom Strombereich des ersten Wandlerteils 31 überlappt, wodurch eine Wandlerkennlinie erhalten wird, wie sie im Prinzip in der Fig. 3, jedoch mit lediglich acht Stufen für den ersten Wandlerteil mit einem fein abgestuften Bereich dargestellt ist.

Der Wandlerteil 31 der Fig. 2 kann dagegen in die Summierleitung 8 einen 123fach abgestuften Strom einspeisen entsprechend der Gleichung

$$Ie = Io \left(S7 + \frac{1}{2} S6 + \frac{1}{4} S5 + \frac{1}{8} S4 + \frac{1}{16} S3 + \frac{1}{32} S2 + \frac{1}{64} S1\right)$$

$$S1 \ldots S7 = 0,1$$

Der zweite Wandlerteil 32 weist unterschiedlich zum ersten Wandlerteil 31 kein R-2R-Netzwerk auf, sondern in Reihe mit elektronischen Schaltern geschaltete Stromquellen Im+1 bis In. Diese Ströme können gleich groß gewählt werden, so daß sich die Wandlerkennlinie der Fig.3 durch Zuschälten jeweils eines Stromes am Ende jeder groben Stufe ergibt. Der Rechner 2 kann aber auch so programmiert werden, daß das gleiche Ergebnis mit einem Wandler 3 erhalten wird, der in der geometrischen Reihe 1, 2, 4, 8, 16... abgestufte Ströme im Wandlerteil 32 aufweist. Dies kann durch Parallelschalten der entsprechenden Anzahl von Schaltern erreicht werden.

Der selbsttätige Abgleichvorgang im Regelsystem nach der Erfindung läuft wie folgt ab:

1. Das Wort A wird vom Tastenfeld in den Rechner (Microcomputer) eingelesen und in das Wort B umgewandelt, was dem Sollwert der Empfängerfrequenz im Falle der Verwendung des Regelsystems zum Einstellen einer Senderfrequenz eines einzustellenden Senders entspricht.

2. Der Wandler 3 wandelt das Wort B in die Spannung Ub, welche an die Kapazitätsdiode des Tuneroszillators angelegt wird und die Oszillatorfrequenz verändert.

3. Die Oszillatorfrequenz wird mit der individuell geforderten Genauigkeit gemessen und in ein Wort C umgewandelt und dem Rechner 3 zur Verfügung gestellt, wie der Fig. 1 zu entnehmen ist.

4. Der Rechner vergleicht das Wort B mit dem Wort C unter Differenzbildung und stellt eine Differenz fest, die dem Korrekturwert $\Delta$ B entpricht, der zu dem Wort B addiert wird, um den Sollwert zu erreichen.

5. Der Abgleichvorgang wird solange wiederholt, bis Wort B gleich Wort C ist.

Bei einem Versuchsweise aufgebauten Regelsystem zum Einstellen von Frequenzen eines Oszillators 4, deren Werte über das Tastenfeld des Sollwertgebers 1 eingegeben werden, wurde ein handelsüblicher Micro-Computer 8080 als Rechner 2 und für die Meßvorrichtung 6 der handelsübliche Binärzähler 74 197 verwendet. Dabei ist zu bemerken, daß zur Verwendung in einem Regelsystem nach der Erfindung auch

H.Klee-1                                             Fl 1044 EP

wesentlich einfacher ausgelegte Rechner als der vorstehend
genannte verwendet werden können. Der Taktgeber 7 stellt
dem Binärzähler 6 eine Torzeit T zu Verfügung, innerhalb
der eine Messung der Oszillatorfrequenz stattfinden kann.
Diese ist entsprechend

$$T = \frac{2^N}{fo}$$

zu bemessen, wobei N = Bitanzahl, d.h. 14 beim vorliegenden
Ausführungsbeispiel und fo = die maximal auftretende
Frequenz des Oszillators 4 bedeuten.

Das Regelsystem nach der Erfindung hat den Vorteil, daß
beispielsweise zur Einstellung einer Oszillatorfrequenz,
es nicht mehr notwendig ist,kostspielige integrierte D/A-
Wandler herkömmlicher Art zu verwenden. Beim Regelsystem
nach der Erfindung werden nämlich bewußt Monotoniefehler
eingegeben, die aber ein Einstellen jeder analogen Spannung
mit großer Genauigkeit ermöglichen. Die Monotoniefehler
werden nämlich durch den Rechner 2 erkannt und jeweils ausgeglichen. Das Regelsystem nach der Erfindung kann also
als ein sich selbst korrigierendes Regelsystem bezeichnet
werden, bei dem ein $\mu$ -Computerfehler der Wandlerkennlinie
errechnet und beseitigt. In einem Regelsystem nach der Erfindung können verschiedene Grundformen von D/A-Wandler verwendet werden, welche aber grundsätzlich schaltungsmäßig
derart unter bewußter Einfügung von Monotoniefehlern abgewandelt werden müssen, daß die Gewichtungen im grob abgestuften Bereich untergewichtet sind, so daß die Summe der
Ströme I1 bis Im im fein abgestuften Strombereich größer
ist als der Strom Im+1 im grob abgestuften Strombereich und
der Strom Im+2 = Im+1 oder 2.Im+1 ist. Im letzten Falle

0043536

H.Klee-1                                                    Fl 1044 EP

wäre der grob abgestufte Bereich in sich nach dem Binärcode abgestuft.

Die Ströme im freien abgestuften Wandlerteil können beispielsweise auch durch abgestufte Stromquellen realisiert
werden. In gleicher Weise können auch bestimmte Widerstände
eines D/A-Wandlers vom R-2R-Typ nach dem oben angegebenen
Prinzip für die Verwendung in einem Regelsystem nach der
Erfindung angepaßt werden.

Die Schalter des Sollwertgebers eines Regelsystems nach der
Erfindung können auch von einem Programmträger betätigt
werden, wie im Prinzip bei der Steuerung von Werkzeugmaschinen bekannt ist.

H.Klee–1

Fl 1044 EP
Go/bk
24. Juni 198[1]

## Patentanspruch

Regelsystem zum Einstellen einer physikalischen Größe auf einen digital vorgegebenen Sollwert mittels eines Abgleichelements, an das ein analoges Abgleichsignal angelegt wird, gekennzeichnet,

- durch ein Tastenfeld von Schaltern eines Sollwertgebers (1),
- durch einen elektronischen Rechner (2), an dessen ersten Eingang (E1) der Sollwert der physikalischen Größe in Form eines Wortes A angelegt wird und der dieses Wort A zunächst in ein digitales Wort B umrechnet, der ferner einen digitalen Subtrahierer enthält, der befähigt ist, die Differenz zwischen dem Wort A und einem an einen zweiten Eingang des Rechners angelegten Wort C zu errechnen und dem Wort B einem Korrekturwert zu addieren,
- durch einen D/A-Wandler (3), an dessen Eingang das Wort B angelegt wird und dessen Ausgangsleitung (5), an die der Eingang des Abgleichelements (4) liegt, über einen Strom-Spannungs-Wandler mit der Summierleitung (8) mindestens zweier Wandlerteile verbunden ist, von denen ein erster Wandlerteil (31) einen fein abgestuften Bereich (S1...Sm) und ein zweiter Wandlerteil (32) einen grob abgestuften Bereich (Sm+1-Sn) aufweisen wobei die Summe der Ströme I1 bis Im größer ist als der Strom Im+1 und wobei der Strom Im+2 gleich Im+1 oder gleich 2.Im+1 ist, und
- durch eine Meßvorrichtung (6), die den Istwert der physikalischen Größe ermittelt und in das Wort C umwandelt.

**Fig. 1**

Fig. 2

2/3

0043536

Fig. 3